# EUROPÄISCHE PATENTSCHRIFT

(11) **EP 4 498 053 B1**
(45) Veröffentlichungstag und Bekanntmachung des Hinweises auf die Patenterteilung: **03.09.2025**
(21) Anmeldenummer: 24217457.1
(22) Anmeldetag: 16.09.2020
(51) Int. Cl.: G01K 7/22, H01C 1/012, H01C 1/14, H01C 7/04, H05K 1/14, H05K 1/03

(54) **SENSORELEMENT UND VERFAHREN ZUR HERSTELLUNG EINES SENSORELEMENTS**
SENSOR ELEMENT AND METHOD FOR MANUFACTURING SENSOR ELEMENT
ÉLÉMENT CAPTEUR ET PROCÉDÉ DE FABRICATION D'UN ÉLÉMENT CAPTEUR

(30) Priorität: 20.11.2019 DE 102019131306
(43) Veröffentlichungstag der Anmeldung: 29.01.2025
(62) Teilanmeldung aus: 20772296.8
(73) Patentinhaber: TDK Electronics AG, 81671 München (DE)
(72) Erfinder: Weidenfelder, Anke, 8042 Graz (AT); Ihle, Jan, 8074 Raaba-Grambach (AT); Stendel, Thomas, 15834 Rangsdorf (DE); Kirsten, Lutz Heiner, 8530 Deutschlandsberg (AT)
(74) Vertreter: Epping - Hermann - Fischer

(56) Entgegenhaltungen:
- EP-B1- 1 227 308
- CN-U- 202 886 007
- DE-A1- 102014 110 553
- US-A1- 2018 122 537
- US-B2- 10 056 175

## Beschreibung

Die vorliegende Erfindung betrifft ein Sensorelement, insbesondere einen Temperatursensor. Die vorliegende Erfindung betrifft weiterhin ein Verfahren zur Herstellung eines Sensorelements, vorzugsweise eines Temperatursensors.

Das Dokument US 10,056,175 B2 beschreibt eine Thermistormontagevorrichtung mit einer Thermistorkomponente auf einem Basissubstrat. Die Thermistorkomponente weist ein isolierendes Substrat, Elektroden und einen Thermistor auf.

Das Dokument DE 10 2014 110 553 A1 beschreibt ein Sensorelement zur Messung einer Temperatur. Das Sensorelement weist schichtförmige Elektroden auf und ist an einer Platine befestigt. Die an einer Oberseite des Sensorelements angeordnete Elektrode ist mit einer ersten Leiterbahn und die an einer Unterseite des Sensorelements angeordnete weitere Elektrode ist mit einer weiteren Leiterbahn der Platine elektrisch verbunden.

Das Dokument US 2018/122537 A1 beschreibt ein elektronisches Bauteil, das einen Temperatursensor mit einem Paar von Elektroden, mindestens einen Metallblock, der elektrisch mit einer Elektrode des Temperatursensors verbunden ist, ein Isolierteil, in das der Temperatursensor und der mindestens eine Metallblock eingebettet sind, und ein mit der Elektrode des Temperatursensors verbundenes externes Terminal, umfasst. Der mindestens eine Metallblock umfasst eine flache Oberfläche, die aus dem Isolierteil herausragt. Die flache Oberfläche definiert das externe Terminal.

Nach dem Stand der Technik werden Temperaturen für die Überwachung und Regelung in unterschiedlichsten Anwendungen vorwiegend mit keramischen Heißleiter-Thermistorelementen ("Negative Temperature Coefficient"; NTC), Silizium-Temperatursensoren (KTY), Platin-Temperatursensoren (PRTD) oder Thermoelementen (TC) gemessen. Dabei sind aufgrund der geringen Herstellkosten die NTC Thermistoren am weitesten verbreitet.

Ein weiterer Vorteil der NTC Thermistoren gegenüber Thermoelementen und metallischen Widerstandselementen, wie z.B. Pt-Elementen, besteht in der ausgeprägten negativen Widerstands-Temperatur-Charakteristik.

Für den Einsatz in Leistungsmodulen werden vorwiegend SMD ("surface mounted device") NTC Temperatursensoren verwendet, die aufgelötet werden. Bei Steuermodulen für geringe Leistungen werden alternativ dazu auch NTC Chips eingesetzt, die an der Unterseite mittels Ag-Sinterpaste, Löten oder Kleben montiert sind und die Oberseite über einen Bonddraht kontaktiert werden.

Für eine elektrische Kontaktierung der NTC Keramik müssen metallische Elektroden aufgebracht werden. Nach dem Stand der Technik werden dazu Dickschichtelektroden vorwiegend aus Silber- bzw. Gold-Pasten über einen Siebdruckprozess mit anschließendem Einbrand aufgebracht.

Die Silber-Metallisierungen eignen sich besonders für Lötverbindungen. Aufgrund der steigenden technologischen Anforderungen hinsichtlich neuer zuverlässiger Anschlusskontaktierungen wie Bonden und Schweißen, ist speziell beim Bonden mit Gold- oder Aluminium- bzw. Kupferdrähten eine andere Elektrode notwendig, da eine Anbindung an Silber keine ausreichende Zuverlässigkeit aufweist.

Im Falle von Gold-Metallisierungen können Lötverbindungen zu Anschlussdrähten nicht realisiert werden. Bondverbindungen werden aus Kostengründen nur mit Gold-Dünndraht realisiert. Aluminium-Bonddrahtverbindungen auf Dickschicht Gold-Elektroden erreichen nicht die Zuverlässigkeitsanforderungen.

Das Sintern unter Druck bei niedrigen Temperaturen mit feindispersen Silberpasten ist im Falle von Gold-Elektroden aufgrund zu geringer Haftfestigkeit und unzureichender Zuverlässigkeit ferner nicht sinnvoll.

Gegenwärtig erfolgt eine Temperaturmessung bei Leistungsmodulen mit aufgelöteten Sensoren auf separaten Leitungspfaden. Die Positionierung auf der Leiterplatte befindet sich in einem separaten Bereich des Leistungsmoduls am Rande oder im Zwischenbereich der Leistungshalbleiter. Eine genaue Temperaturmessung ist daher nur sehr eingeschränkt möglich, da nur eine indirekte thermische Verbindung über das Keramiksubstrat besteht.

Auf Grund der steigenden Anforderungen bezüglich Einsatztemperatur und Zuverlässigkeit besteht jedoch die Forderung nach NTC Temperatursensoren, die vorzugsweise direkt auf die Leiterbahnen der Platine aufgebracht werden können.

Aufgabe der vorliegenden Erfindung ist es ein Sensorelement und ein Verfahren zur Herstellung eines Sensorelements zu beschreiben, welche die oben stehenden Probleme lösen.

Diese Aufgabe wird durch ein Sensorelement und ein Verfahren zur Herstellung eines Sensorelements gemäß der unabhängigen Ansprüche gelöst.

Gemäß einem Aspekt wird ein Sensorelement beschrieben. Das Sensorelement ist zur Messung einer Temperatur ausgebildet. Das Sensorelement ist ein Temperatursensor. Das Sensorelement ist zur Temperaturmessung bei Leistungsmodulen ausgebildet.

Das Sensorelement weist einen Träger bzw. ein Substrat auf. Der Träger ist elektrisch isolierend ausgebildet. Insbesondere weist der Träger ein elektrisch isolierendes Material auf. Der Träger weist ein Material mit einer hohen Wärmeleitfähigkeit auf. Der Träger weist bevorzugt ein keramisches Material auf. Der Träger ist ein keramischer Träger.

Der Träger weist eine Oberseite und eine Unterseite auf. Ober- und Unterseite liegen einander gegenüber. Die Unterseite ist dabei diejenige Seite des Trägers bzw. des Sensorelements welche im verbauten Zustand des Sensorelements einer Leiterplatte zugewandt ist.

Das Sensorelement weist ferner einen NTC Thermistor auf. Der NTC Thermistor ist an der Oberseite des Trägers angeordnet. In einer ersten Variante ist der NTC Thermistor ein SMD NTC Thermistor. In einer zweiten Variante ist der NTC Thermistor ein Chip NTC Thermistor. Der NTC Thermistor weist eine Oberseite und eine Unterseite auf. Ober- und Unterseite liegen einander gegenüber. Die Oberseite ist dabei diejenige Seite des NTC Thermistors, welche im verbauten Zustand des Sensorelements von dem Träger abgewandt ist.

Das Sensorelement weist wenigstens zwei erste bzw. obere Elektroden auf. Insbesondere weist das Sensorelement eine erste obere Elektrode auf. Das Sensorelement weist ferner eine zweite obere Elektrode auf.

Die ersten/oberen Elektroden sind zur elektrischen Kontaktierung des Sensorelements und/oder des NTC Thermistors ausgebildet. Die ersten/oberen Elektroden sind an der Oberseite des Trägers angeordnet. Die ersten/oberen Elektroden sind räumlich und elektrisch voneinander separiert auf der Oberfläche des Trägers ausgebildet. Die ersten Elektroden sind strukturiert ausgebildet.

Das Sensorelement weist wenigstens eine zweite bzw. untere Elektrode, vorzugsweise genau eine zweite Elektrode, auf. Die zweite/untere Elektrode ist eine reine Metallisierung und weist keine elektrische Funktion auf. Die zweite Elektrode ist an der Unterseite des Trägers angeordnet bzw. ausgebildet. Vorzugsweise ist die zweite Elektrode vollflächig ausgebildet. Mit anderen Worten, die zweite Elektrode bedeckt die Unterseite vollständig. Die zweite Elektrode kann auch so ausgebildet und angeordnet sein, dass an der Unterseite des Trägers ein Freirand ausgebildet ist. In diesem Fall ragt die zweite Elektrode nicht bis an den Rand der Unterseite des Trägers.

Das Sensorelement ist dazu ausgebildet elektrisch isolierend direkt integriert zu werden, beispielsweise auf eine Leiterbahn eines Leistungsmoduls. Dadurch wird eine exakte Temperaturüberwachung an der gewünschten Position gewährleistet, da die thermische Kopplung zum IC (Integrated Circuit; integrierter Schaltkreis) direkt über die Leiterbahn gegeben ist. Damit wird ein sehr präzises und zuverlässiges Sensorelement bereitgestellt.

Gemäß einem Ausführungsbeispiel weist das Material des Trägers eine Keramik auf Basis von Al₂O₃, LTCC ("Low Temperature Cofired Ceramics"; Niedertemperatur-Einbrand-Keramiken)oder ZTA ("Zirconia Toughened Aluminum Oxide"; Zirkoniumdioxidverstärktes Aluminiumoxid) Materialien auf. Alternativ dazu kann das Trägermaterial auch AlN oder Si₃N₄ aufweisen. Diese Materialen erhöhen die mechanische Stabilität des Sensorelements. Damit wird ein besonders zuverlässiges Sensorelement bereitgestellt.

Gemäß einem Ausführungsbeispiel sind die Wärmeausdehnungskoeffizienten des Trägermaterials und eines Materials des NTC Thermistors aufeinander abgestimmt. Damit können Schädigungen der Verbindungsstellen zwischen NTC Thermistor und Träger durch zyklische Temperaturwechsel und dabei auftretenden thermomechanischen Spannungen vermieden werden.

Gemäß einem Ausführungsbeispiel sind die ersten bzw. oberen Elektroden dazu ausgebildet und angeordnet, eine elektrische Kontaktierung des Sensorelements mit konventioneller AVT (Aufbau- und Verbindungstechnik) zu ermöglichen. Vorzugsweise sind die ersten Elektroden so ausgebildet, dass sie mittels Löten und/oder Drahtbonden (bevorzugt Dickdrahtbonden) kontaktierbar sind.

Weiterhin ist die zweite bzw. untere Elektrode dazu ausgebildet und angeordnet mit konventioneller AVT direkt auf die Leiterbahn des Leistungsmoduls aufgebracht zu werden. Vorzugsweise wird die zweite Elektrode mittels Löten oder Silbersintern auf der Leiterbahn integriert.

Damit kommen Verbindungstechniken zum Einsatz, welche standardmäßig bei der Herstellung von Leistungsmodulen verwendet werden. Dies ermöglicht die Bereitstellung eines kostengünstigen und einfachen Sensorelements.

Gemäß einem Ausführungsbeispiel weist die jeweilige erste bzw. obere Elektrode eine Mehrzahl von Schichten auf. Bevorzugt weist die jeweilige erste Elektrode wenigstens zwei Schichten auf. Jede Schicht kann eine Vielzahl von einzelnen Lagen oder Unterschichten aufweisen. Die Schichten sind je nach Material als Dünn- bzw. Dickschicht ausgeführt. Jede Schicht der jeweiligen ersten Elektrode weist ein spezifisches Material auf.

In der ersten Variante (SMD NTC Thermistor) weist die jeweilige erste Elektrode bevorzugt die Materialien Cu, Ni und Au auf. In der zweiten Variante (Chip NTC Thermistor) weist die erste Elektrode des Trägers die Materialien Cu, Ni, Pd und/oder Au auf und die Elektrode auf dem Chip NTC Thermistor weist die Materialien Ni und Au auf. Optional kann die jeweilige erste Elektrode auch Pd aufweisen.

Beispielsweise weist auf dem Träger eine unterste Schicht der ersten Elektrode Cu auf. Die unterste Schicht ist dabei diejenige Schicht der ersten Elektrode, welche direkt bzw. unmittelbar auf der Oberseite des Trägers ausgebildet ist. Beispielsweise weist eine mittlere Schicht Ni auf. Beispielsweise weist eine zweite oder weitere mittlere Schicht Pd auf. Eine oberste Schicht weist beispielsweise Au auf. Die oberste Schicht bildet die Oberseite bzw. Außenseite der jeweiligen ersten Elektrode.

Vorzugsweise ist auf dem Träger wenigstens eine Schicht der ersten Elektrode als Dickschicht ausgebildet. Wenigstens eine weitere Schicht der ersten Elektrode ist ferner als Dünnschicht ausgebildet. Die Cu Schicht und die Ni Schicht sind bevorzugt als Dickschichten ausgeführt. Die Au Schicht sowie die Pd Schicht sind vorzugsweise als Dünnschichten ausgeführt.

Die Schichtdicken variieren dabei ≤ 1 µm bis ≤ 20 µm, wobei die als Dickschicht ausgeführten Cu und Ni-Schichten jeweils bis zu 20 µm dick sein können. Die Pd- und Au- Schichten weisen jeweils eine Schichtstärke von ≤ 1 µm auf. Die Schichtabfolge und -stärke ist dabei so gewählt, dass insbesondere ein zuverlässiger Löt- und Al-Dickdrahtbondprozess ermöglicht wird.

Durch den speziellen Aufbau der ersten bzw. oberen Elektroden ist eine Kontaktierung beispielsweise mit Al-Dickdraht ohne Beschädigung der NTC Keramik sowie mit gesteigerter Zuverlässigkeit im Vergleich zu standardmäßigen NTC Thermistoren möglich.

Gemäß einem Ausführungsbeispiel weist die jeweilige erste bzw. obere Elektrode einen ersten Bereich auf zur elektrischen Kontaktierung des Sensorelements. Vorzugsweise erfolgt die elektrische Kontaktierung mittels Drahtbonden (bevorzugt Al-Dickdrahtbonden) oder Löten. Die jeweilige erste Elektrode weist ferner einen zweiten Bereich auf zur Anbindung bzw. Kontaktierung des NTC Thermistors. Vorzugsweise wird der NTC Thermistor mittels Löten an dem jeweiligen zweiten Bereich befestigt.

Der erste Bereich und der zweite Bereich sind durch einen Verbindungsbereich miteinander verbunden bzw. verknüpft.

Durch die spezifische Ausgestaltung bzw. Strukturierung der jeweiligen ersten Elektrode wird die Bereitstellung eines kostengünstigen, stabilen und zuverlässigen Sensorelements ermöglicht.

Erfindungsgemäß ist (lediglich) eine erste der beiden ersten/oberen Elektroden unmittelbar auf der Oberseite des Trägers ausgebildet. Der Einfachheit halber wird die erste der beiden ersten/oberen Elektroden im Folgenden als die erste obere Elektrode bezeichnet. Die erste obere Elektrode ist analog zu den oben beschriebenen ersten Elektroden ausgeführt. Insbesondere ist die erste obere Elektrode mehrschichtig ausgeführt.

Die erste obere Elektrode stellt eine Metallisierung des keramischen Trägers dar. Der NTC Thermistor ist in diesem Ausführungsbeispiel ein Chip NTC Thermistor (Variante 2). Der NTC Thermistor ist direkt bzw. unmittelbar auf der ersten oberen Elektrode angeordnet, beispielsweise aufgelötet, Ag-gesintert oder geklebt. Die Dicke des NTC Thermistors beträgt vorzugsweise 0,2 mm bis 0,7 mm. Der NTC Thermistor hat bevorzugt eine Fläche von (1,25 ± 0,75) mm x (1,5 ± 1,0) mm. Vorzugsweise ist der Chip NTC Thermistor in einem Randbereich der ersten oberen Elektrode angeordnet. Die vom NTC Thermistor frei bleibende Fläche der ersten oberen Elektrode dient als ein (erstes) Bondpad. Damit wird die elektrische Kontaktierung des NTC Thermistors auf einfache Weise gewährleistet.

Die erste obere Elektrode ist erfindungsgemäß vollflächig auf der Oberseite des Trägers ausgeführt. Beispielsweise weist die erste obere Elektrode eine Fläche von (1,25 ± 0,75) mm x (2,25 ± 1,25) mm auf.

Alternativ dazu kann die erste obere Elektrode die Oberseite des Trägers auch nur teilweise bedecken. Beispielsweise ist ein Freirand ausgebildet, also ein Randbereich der Oberseite, welcher frei von der ersten oberen Elektrode ist. Beispielsweise hat der Freirand eine Abmessung von 0,1 mm bis 0,25 mm.

Gemäß einem Ausführungsbeispiel weist der Chip NTC Thermistor eine Metallisierung auf. Die Metallisierung ist an der Oberseite und an der Unterseite des NTC Thermistors ausgebildet. Die Metallisierung ist zur elektrischen Kontaktierung des Sensorelements, beispielsweise mittels Drahtbonden, ausgebildet. Die Metallisierung fungiert als Elektrode des Chip NTC Thermistors.

Vorzugsweise bedeckt die Metallisierung die Oberseite des Chip NTC Thermistors vollständig. Die Metallisierung des Chip NTC Thermistors dient als ein weiteres oder zweites Bondpad, beispielsweise für eine Al-Dickdraht Kontaktierung. Mit anderen Worten, die Metallisierung bildet eine zweite der beiden ersten/oberen Elektroden. Der Einfachheit halber wird die zweite der beiden ersten/oberen Elektroden im Folgenden als die zweite obere Elektrode bezeichnet. Die metallisierte Oberseite des Chip NTC Thermistors fungiert damit als zweite obere Elektrode des Sensorelements. Dadurch wird die elektrische Kontaktierung des Sensorelements auf einfache Weise sichergestellt.

Gemäß einem Ausführungsbeispiel weist die Metallisierung bzw. die zweite obere Elektrode wenigstens eine Schicht enthaltend Nickel auf. Diese Schicht ist direkt bzw. unmittelbar auf einem keramischen Grundkörper des Chip NTC Thermistors aufgebracht. Die Schicht kann auch aus Nickel bestehen. Die Dicke der nickelhaltigen Schicht liegt beispielsweise im Bereich von 0,3 µm bis 10 µm. Eine nickelhaltige Schicht erlaubt eine besonders gute mechanische und elektrische Anbindung, insbesondere an die Keramik des NTC Thermistors.

Gemäß einem Ausführungsbeispiel enthält die Schicht zusätzlich einen Anteil an Vanadium. Ein Anteil an Vanadium kann insbesondere aus prozesstechnischen Gründen für ein Sputterverfahren von Vorteil sein. Beispielsweise ist Vanadium in einem Gewichtsanteil von 7% in der nickelhaltigen Schicht vorhanden. Nickel ist beispielsweise in einem Gewichtsanteil von 93% vorhanden.

Gemäß einem Ausführungsbeispiel weist die Metallisierung bzw. die zweite obere Elektrode wenigstens eine weitere Schicht enthaltend Au auf. Mi anderen Worten der Schichtaufbau der zweiten oberen Elektrode ist Ni/Au mit Au als oberste Elektrode. Die Dicke der Au Schicht liegt zwischen 0,1 µm und 0,3 µm, idealerweise bei 0,2 µm.

In einer Ausführungsform weist die Metallisierung wenigstens eine gesputterte Schicht auf. Beispielsweise sind alle Schichten durch Sputtern aufgebracht. Vorzugsweise ist die Metallisierung frei von einer eingebrannten Paste. Bei einer gesputterten Metallisierung besteht ein Vorteil in der geringeren thermischen Belastung des Sensorelements im Herstellungsprozess, insbesondere durch den Wegfall eines Einbrennens einer Metallisierungspaste bei Temperaturen von beispielsweise 700°C bis 900°C. Weiterhin erlaubt ein Sputterprozess eine besonders kostengünstige Herstellung.

Beispielsweise handelt es sich bei der Metallisierung um eine Dünnschichtmetallisierung. Beispielsweise weist die gesamte Metallisierung eine Dicke im Bereich von 0,3 µm bis 10 µm auf.

Gemäß einem Ausführungsbeispiel weist die Metallisierung mehrere Schichten auf, die direkt übereinander angeordnet sind. Beispielsweise weist die Metallisierung eine untere und eine obere Schicht auf. Die untere Schicht ist vorzugsweise in direktem Kontakt mit der Keramik des Grundkörpers. Die obere Schicht ist beispielsweise direkt auf der unteren Schicht aufgebracht. Vorzugsweise sind beide Schichten gesputtert. Die Metallisierung kann auch mehr als zwei Schichten aufweisen.

Beispielsweise enthält die untere Schicht Chrom oder besteht aus Chrom. Eine chromhaltige Schicht kann insbesondere als Haftvermittler zur Keramik vorteilhaft sein. Beispielsweise enthält die obere Schicht Nickel oder besteht aus Nickel. Zusätzlich kann die obere Schicht einen Anteil an Vanadium aufweisen.

Gemäß einem Ausführungsbeispiel ist die zweite bzw. untere Elektrode oder Metallisierung mehrschichtig ausgebildet. Beispielsweise kann die zweite Elektrode einen Schichtaufbau aufweisen, welcher dem Schichtaufbau der ersten Elektrode entspricht. Die zweite Elektrode kann die Materialien Cu, Ni, Pd und/oder Au aufweisen. In diesem Fall kann die zweite Elektrode an der Oberseite bzw. Außenseite eine Metallisierung aufweisen, um die Silbersinterbarkeit des Sensorelements zu gewährleisten.

Alternativ dazu kann die zweite Elektrode aber auch nur eine oder mehrere Schichten eines anderen spezifischen Materials aufweisen. Beispielsweise weist die zweite Elektrode wenigstens eine Schicht des Materials Ag auf. Dadurch wird die Silbersinterbarkeit der zweiten Elektrode ohne zusätzliche Schichten (Metallisierung) ermöglicht. Damit wird der Aufbau des Sensorelements vereinfacht.

Gemäß einem Ausführungsbeispiel kann das Sensorelement auch ohne zweite/untere Elektrode ausgeführt sein. Dies stellt eine Vereinfachung des Aufbaus dar. Das Sensorelement ist in diesem Fall für eine Montage mit einen Klebeprozess vorgesehen.

Gemäß einem Ausführungsbeispiel weist das Sensorelement wenigstens eine Haftvermittlungsschicht auf, beispielsweise eine Ti-Schicht. Die Haftvermittlungsschicht kann zwischen der jeweiligen ersten Elektrode und dem Träger, insbesondere der Oberseite des Trägers, ausgebildet sein. Alternativ oder zusätzlich kann die Haftvermittlungsschicht zwischen der zweiten Elektrode und dem Träger, insbesondere der Unterseite des Trägers, ausgebildet sein. Damit wird die Zuverlässigkeit der Anbindung der Elektroden an das Trägermaterial erhöht.

Gemäß einem Ausführungsbeispiel weist das Sensorelement wenigstens eine Schutzschicht oder Schutzhülle auf. Die Schutzschicht ist zumindest um den NTC Thermistor herum ausgebildet. In diesem Fall ist der NTC Thermistor ein SMD NTC Thermistor. Vorzugsweise hüllt die Schutzschicht den NTC Thermistor vollständig ein. Die Schutzschicht kann ein Epoxidharz aufweisen. Die Schutzschicht kann als Globtop ausgebildet sein. Die Schutzschicht dient dazu die Zuverlässigkeit und Lebensdauer des Sensorelements auf einfache Weise zu steigern.

Gemäß einem weiteren Aspekt wird ein Verfahren zur Herstellung eines Sensorelements beschrieben. Vorzugsweise wird durch das Verfahren das oben beschriebene Sensorelement hergestellt. Alle Eigenschaften, die in Bezug auf das Sensorelement oder das Verfahren offenbart sind, sind auch entsprechend in Bezug auf den jeweiligen anderen Aspekt offenbart und umgekehrt, auch wenn die jeweilige Eigenschaft nicht explizit im Kontext des jeweiligen Aspekts erwähnt wird. Das Verfahren weist die folgenden Schritte auf, wobei die Reihenfolge der Schritte nicht durch die folgende Aufstellung festgelegt ist:
A) Bereitstellen eines Trägermaterials zur Ausbildung des Trägers. Das Trägermaterial ist elektrisch isolierend ausgebildet. Das Trägermaterial weist eine hohe Wärmeleitfähigkeit auf. Das Trägermaterial weist ein keramisches Material auf. Bevorzugt weist das Trägermaterial eine Keramik auf Basis von Al₂O₃, LTCC oder ZTA Materialien auf. Alternativ dazu kann das Trägermaterial auch AlN oder Si₃N₄ aufweisen.
B) Aufbringen von wenigstens zwei ersten bzw. oberen Elektroden auf einer Oberseite des Trägermaterials. Die ersten Elektroden sind strukturiert ausgebildet. Die ersten Elektroden sind mehrschichtig ausgebildet. Die ersten Elektroden werden durch einen kombinierten Prozess aus Sputtern, CVD ("chemical vapour deposition"; chemische Gasphasenabscheidung) Prozess, PVD ("physical vapour deposition"; physikalische Gasphasenabscheidung) Prozess und/oder galvanischem Abscheiden auf die Oberseite des Trägermaterials aufgebracht.

Das Aufbringen der mehrschichtigen Elektroden erfolgt insbesondere durch eine Kombination von verschiedenen Abscheideverfahren zur Erzeugung von sowohl Dick- als auch Dünnschichten. Zusätzlich ist ein Lithographie Prozess zur Strukturierung der Metallisierung notwendig. Insbesondere ist die Prozessabfolge zum Aufbringen der wenigstens zwei ersten bzw. oberen Elektroden auf der Oberseite des Trägermaterials wie folgt:
a.: Nasschemische Reinigung;
b.1: Sputtern Ti (das kann je nach Anlage für Ober-und Unterseite gleichzeitig oder nacheinander erfolgen);
b.2: Sputtern Cu (das kann je nach Anlage für Ober-und Unterseite gleichzeitig oder nacheinander erfolgen);
c.1: Laminieren;
c.2: Belichten;
c.c3: Entwickeln (Schritt 1 der Lithographie);
d.: Cu galvanisch (gleichzeitig für Unter- und Oberseite);
e.: Strippen (Lack entfernen - Schritt 2 der Lithographie);
f.: Electroless nickel immersion gold ("Chemisches Nickel-Immersionsgold"; ENIG):
f.1: Reinigung;
f.2: Katalyse mit Pd;
f.3: Nickel stromlos abscheiden (nasschemisch);
f.4: Immersionsgold (auch bezeichnet als Sudgold, Tauchgold, oder Flashgold).

Die resultierenden ersten Elektroden weisen eine Mehrzahl von Dickschichten und Dünnschichten verschiedener Materialien auf. Die ersten Elektroden weisen beispielsweise Cu, Ni, Pd und/oder Au auf.

C) Aufbringen von wenigstens einer zweiten bzw. unteren Elektrode an einer Unterseite des Trägermaterials. Die zweite Elektrode kann als Dünnschicht oder als Dickschicht ausgebildet sein. Beispielsweise wird die zweite Elektrode mittels Sputtern erzeugt. Alternativ dazu kann die zweite Elektrode durch einen kombinierten Prozess aus Sputtern, CVD Prozess, PVD Prozess und/oder galvanischem Abscheiden auf die Unterseite des Trägermaterials aufgebracht werden. In diesem Fall weist die zweite Elektrode einen Schichtaufbau aus unterschiedlichen Materialien auf.

Das Aufbringen der mehrschichtigen Elektrode erfolgt insbesondere - wie bereits in Zusammenhang mit der mehrschichten oberen Elektrode beschrieben - durch eine Kombination von verschiedenen Abscheideverfahren zur Erzeugung von sowohl Dick- als auch Dünnschichten. Zusätzlich ist ein Lithographie Prozess zur Strukturierung der Metallisierung notwendig. Insbesondere ist die Prozessabfolge zum Aufbringen der wenigstens (zweiten/unteren) Metallisierung auf der Unterseite des Trägermaterials wie folgt:
a.: Nasschemische Reinigung;
b.1: Sputtern Ti (das kann je nach Anlage für Ober-und Unterseite gleichzeitig oder nacheinander erfolgen);
b.2: Sputtern Cu (das kann je nach Anlage für Ober-und Unterseite gleichzeitig oder nacheinander erfolgen);
c.1: Laminieren;
c.2: Belichten;
c.c3: Entwickeln (Schritt 1 der Lithographie);
d.: Cu galvanisch (gleichzeitig für Unter- und Oberseite);
e.: Strippen (Lack entfernen - Schritt 2 der Lithographie);
f.: Electroless nickel immersion gold:
f.1: Reinigung;
f.2: Katalyse mit Pd;
f.3: Nickel stromlos abscheiden (nasschemisch);
f.4: Immersionsgold (auch bezeichnet als Sudgold, Tauchgold, oder Flashgold).

In einem weiteren Schritt kann eine Metallisierung auf der Unterseite der zweiten Elektrode aufgebracht werden. Diese Metallisierung kann durch einen CVD Prozess, einen PVD Prozess oder durch galvanische Abscheidung erzeugt werden.

D) Anordnen eines NTC Thermistors (SMD NTC Thermistor) auf der Oberseite des Trägermaterials. Der NTC Thermistor wird auf einen Teilbereich der wenigstens zwei ersten Elektroden aufgebracht, vorzugsweise aufgelötet.

Nunmehr weist das Sensorelement alle Eigenschaften auf, um ein direktes Anbinden des Sensorelements auf eine Leiterbahn einer Leiterplatte zu ermöglichen. Dies erfolgt durch Löten oder Ag-Sintern der zweiten Elektrode. Ferner können auch die der ersten Elektroden und/oder der NTC Thermistor elektrisch kontaktiert werden, insbesondere mittels Drahtbonden und/oder Löten.

Das Sensorelement zeichnet sich insbesondere dadurch aus, dass es direkt auf die Leiterbahn eines Leistungsmoduls integriert werden kann. Durch den speziellen Aufbau der Elektroden kann das Sensorelement mit konventioneller AVT, wie Löten, Silbersintern und/oder (Dick-/Dünn-)drahtbonden verarbeitet werden. Dadurch wird ein besonders genaues, zuverlässiges und kostengünstiges Sensorelement erzeugt.

Gemäß einem weiteren Aspekt wird ein Verfahren zur Herstellung eines Sensorelements beschrieben. Vorzugsweise wird durch das Verfahren das oben beschriebene Sensorelement hergestellt. Alle Eigenschaften, die in Bezug auf das Sensorelement oder das Verfahren offenbart sind, sind auch entsprechend in Bezug auf den jeweiligen anderen Aspekt offenbart und umgekehrt, auch wenn die jeweilige Eigenschaft nicht explizit im Kontext des jeweiligen Aspekts erwähnt wird. Das Verfahren weist die folgenden Schritte auf:
A) Bereitstellen eines Trägermaterials zur Ausbildung des Trägers. Das Trägermaterial ist elektrisch isolierend ausgebildet. Das Trägermaterial weist eine hohe Wärmeleitfähigkeit auf. Das Trägermaterial weist ein keramisches Material auf. Bevorzugt weist das Trägermaterial eine Keramik auf Basis von Al₂O₃, LTCC oder ZTA Materialien auf. Alternativ dazu kann das Trägermaterial auch AlN oder Si₃N₄ aufweisen.
B) Aufbringen einer ersten oberen Elektrode auf einer Oberseite des Trägermaterials. Die erste Elektrode kann strukturiert ausgebildet sein. Die erste Elektrode bedeckt erfindungsgemäß die Oberseite des Trägers vollflächig.

Alternativ dazu bedeckt die erste obere Elektrode lediglich einen Teilbereich der Oberfläche des Trägers, so dass ein Randbereich der Oberseite frei von der ersten oberen Elektrode bleibt.

Die erste Elektrode ist vorzugsweise mehrschichtig ausgebildet. Die erste obere Elektrode wird durch einen kombinierten Prozess aus Sputtern, CVD ("chemical vapour deposition"; chemische Gasphasenabscheidung) Prozess, PVD ("physical vapour deposition"; physikalische Gasphasenabscheidung) Prozess und/oder galvanischem Abscheiden auf die Oberseite des Trägermaterials aufgebracht.

Das Aufbringen der mehrschichtigen ersten oberen Elektrode erfolgt insbesondere durch eine Kombination von verschiedenen Abscheideverfahren zur Erzeugung von sowohl Dick- als auch Dünnschichten. Zusätzlich ist ein Lithographie Prozess zur Strukturierung der Metallisierung notwendig, wie bereits oben beschrieben wurde.

Die resultierende erste obere Elektrode weist eine Mehrzahl von Dickschichten und Dünnschichten verschiedener Materialien auf. Die erste obere Elektrode weist beispielsweise Cu, Ni, Pd und/oder Au auf.

C) Aufbringen von wenigstens einer zweiten bzw. unteren Elektrode an einer Unterseite des Trägermaterials. Die zweite Elektrode kann als Dünnschicht oder als Dickschicht ausgebildet sein. Beispielsweise wird die zweite Elektrode mittels Sputtern erzeugt. Alternativ dazu kann die zweite Elektrode durch einen kombinierten Prozess aus Sputtern, CVD Prozess, PVD Prozess und/oder galvanischem Abscheiden auf die Unterseite des Trägermaterials aufgebracht werden. In diesem Fall weist die zweite Elektrode einen Schichtaufbau aus unterschiedlichen Materialien auf.

Das Aufbringen der mehrschichtigen Elektrode erfolgt insbesondere durch eine Kombination von verschiedenen Abscheideverfahren zur Erzeugung von sowohl Dick- als auch Dünnschichten. Zusätzlich ist ein Lithographie Prozess zur Strukturierung der Elektrode notwendig, wie bereits oben beschrieben wurde.

In einem weiteren Schritt kann eine Metallisierung auf der Unterseite der zweiten Elektrode aufgebracht werden. Die Metallisierung kann durch einen CVD Prozess, einen PVD Prozess oder durch galvanische Abscheidung erzeugt werden.

D) Anordnen eines NTC Thermistors (Chip NTC Thermistor) auf einen Teilbereich der ersten oberen Elektrode. Der NTC Thermistor wird bevorzugt auf einen Randbereich der ersten oberen Elektrode aufgelötet, Ag-gesintert oder geklebt. Derjenige Bereich der ersten oberen Elektrode, welcher frei von dem NTC Thermistor bleibt, fungiert als ein erstes Bondpad des Sensorelements.

Der Chip NTC Thermistor weist eine Metallisierung an der Oberseite auf. Die Metallisierung ist bevorzugt eine Dünnschichtmetallisierung. Die Metallisierung ist vorzugsweise auf die Oberseite des NTC Thermistors aufgesputtert. Die Metallisierung bildet eine zweite obere Elektrode des Sensorelements. Die Metallisierung fungiert als ein zweites Bondpad des Sensorelements.

Im Falle der Variante 2 mit einem Chip NTC Thermistor besteht die Möglichkeit einen Chip mit einem symmetrischen Aufbau zu verwenden, wobei auf der Unter- und Oberseite die Elektrode die gleichen Schichten aufweist. Alternativ kann aber auch ein Chip verwendet werden, der einen asymmetrischen Aufbau hat, wobei sich die Schichten der Elektroden auf der Unter- und Oberseite voneinander unterscheiden. Beispielsweise kann auf der Unterseite eine Nickelschicht mit einer Silberdeckschicht aufgebracht sein und auf der Oberseite eine Nickelschicht mit einer Golddeckschicht kombiniert sein. Der Vorteil besteht darin, dass für das Fügen auf dem Träger durch die Ag-Schicht eine bessere Anhaftung beim Silberdrucksintern und Löten erzielt wird. Die Dicke der Schichten unterscheidet sich zwischen der Ober- und Unterseite. In einem Beispiel weist die Unterseite eine 0,3 µm dicke Nickelschicht auf, die mit einer 0,4 µm dicken Silberschicht bedeckt ist. Auf der Oberseite ist in diesem konkreten Beispiel dann eine 1,1 µm dicke Nickelschicht von einer 0,2 µm dicken Goldschicht bedeckt. Selbstverständlich sind auch andere Variationen in der Schichtdicke und Materialkombinationen möglich.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.

Es zeigen:
- Figur 1: eine Seitenansicht eines Sensorelements gemäß einem Ausführungsbeispiel,
- Figur 2: eine perspektivische Draufsicht auf ein Sensorelement gemäß einem weiteren Ausführungsbeispiel,
- Figur 3: eine perspektivische Unteransicht des Sensorelements gemäß Figur 2,
- Figur 4: eine schematische Darstellung des Schichtaufbaus einer ersten Elektrode,
- Figur 5: eine Draufsicht auf ein Sensorelement gemäß einem weiteren Ausführungsbeispiel,
- Figur 6: eine perspektivische Ansicht eines Teils des Sensorelements (NTC Chip Thermistor) gemäß Figur 5.

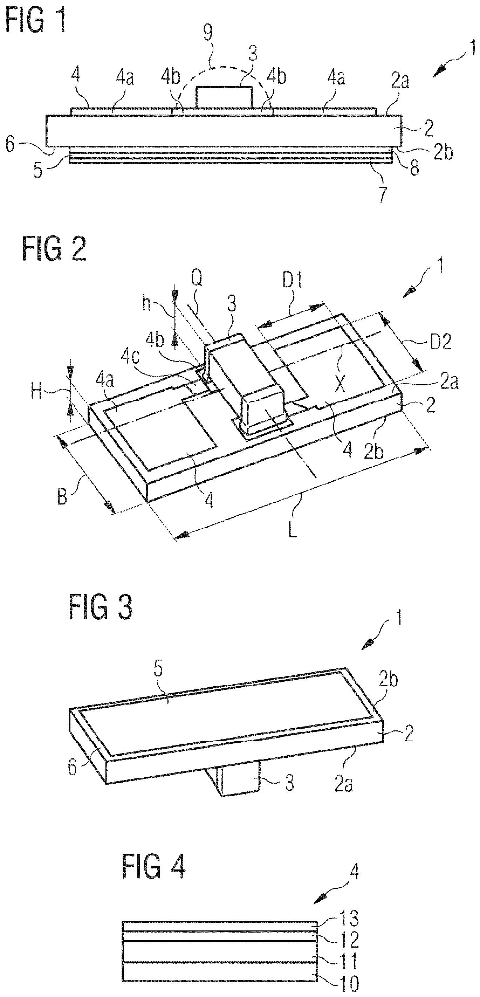

Die Figur 1 zeigt ein Sensorelement 1 gemäß einer ersten Ausführungsform. Das Sensorelement 1 ist vorzugsweise zur Messung einer Temperatur ausgebildet. Das Sensorelement 1 ist ein Temperatursensor. Das Sensorelement 1 ist dazu ausgebildet mit konventioneller AVT, wie Löten, Silbersintern und/oder Drahtbonden, die standardmäßig bei der Herstellung von Leistungsmodulen verwendet werden, verarbeitet zu werden.

Das Sensorelement 1 weist einen Träger 2 auf. Der Träger 2 weist ein gut wärmeleitfähiges und elektrisch isolierendes Material auf. Vorzugsweise ist der Träger 2 ein keramischer Träger. Bevorzugt weist der Träger 2 eine Keramik auf Basis von Al₂O₃, LTCC oder ZTA Materialien auf. Alternativ dazu kann der Träger AlN oder Si₃N₄ als Trägermaterial aufweisen.

Der Träger 2 weist eine Oberseite 2a und eine Unterseite 2b auf. Die Unterseite 2b ist dabei diejenige Seite des Trägers 2 welche im verbauten Zustand des Sensorelements 1 einer Leiterplatte zugewandt ist.

Der Träger 2 ist rechteckig ausgebildet. Gemäß einem Ausführungsbeispiel weist der Träger 2 eine Breite B auf (siehe Figur 2), wobei 1,5 mm ≤ B ≤ 2 mm. Bevorzugt beträgt die Breite B = 1,6 mm**.** Selbstverständlich sind auch andere (kleinere oder größere) Breiten vorstellbar, beispielsweise 0,5 mm ≤ B ≤ 2 mm.

Gemäß einem Ausführungsbeispiel weist der Träger 2 eine Dicke bzw. Höhe H auf (siehe Figur 2), wobei 0,3 mm ≤ H ≤ 0,5 mm. Bevorzugt beträgt die Höhe H = 0,4 mm. Es sind aber auch andere (kleinere oder größere) Höhen vorstellbar, beispielsweise 0,1 mm ≤ H ≤ 1,0 mm.

Gemäß einem Ausführungsbeispiel weist der Träger 2 eine Länge L auf (siehe Figur 2), wobei 3,0 mm ≤ L ≤ 4,0 mm. Bevorzugt beträgt die Länge L = 3,5 mm. Auch kleinere und größere Ausführungsformen sind vorstellbar, beispielsweise 1 mm ≤ L ≤ 4 mm.

Mit anderen Worten, das Sensorelement 1 bzw. der Träger 2 ist sehr kompakt dimensioniert und eignet sich damit hervorragend zur Integration auf eine Leiterplatte.

Das Sensorelement 1 weist ferner wenigstens zwei erste bzw. obere Elektroden 4 und wenigstens eine zweite bzw. untere Elektrode 5 auf. Die zweite bzw. untere Elektrode 5 ist vorzugsweise eine reine Metallisierung und weist keine elektrische Funktion auf.

Die wenigstens zwei ersten Elektroden 4 sind auf der Oberseite 2a des Trägers 2 ausgebildet. Die ersten Elektroden 4 sind dazu ausgebildet und angeordnet, eine elektrische Kontaktierung des Sensorelements 1 mit konventioneller AVT (vorzugsweise Drahtbonden oder Löten) zu ermöglichen.

Die jeweilige erste Elektrode 4 ist strukturiert ausgebildet. Die jeweilige erste Elektrode 4 weist beispielsweise die Materialien Cu, Ni, Pd und/oder Au auf. Die jeweilige erste Elektrode 4 ist mehrschichtig aufgebaut (siehe hierzu Figur 4). Insbesondere weist eine unterste Schicht 10 der ersten Elektrode 4 Cu auf. Die unterste Schicht 10 ist dabei diejenige Schicht der ersten Elektrode 4, welche direkt bzw. unmittelbar auf der Oberseite 2a des Trägers 2 ausgebildet ist. Eine erste mittlere Schicht 11 der ersten Elektrode 4 weist Ni auf. Die erste mittlere Schicht 11 grenzt dabei direkt an die unterste Schicht 10 an. Eine zweite mittlere Schicht 12 der ersten Elektrode 4 weist beispielsweise Pd auf. Die zweite mittlere Schicht 12 grenzt dabei direkt an die erste mittlere Schicht 11 an. Eine oberste Schicht 13 der ersten Elektrode 4 weist Au auf. Die oberste Schicht 13 grenzt dabei direkt an die zweite mittlere Schicht 12 an. Die oberste Schicht 13 bildet die Oberseite bzw. Außenseite der jeweiligen ersten Elektrode 4.

Die Schichten 10, 11, 12, 13 sind je nach Material als Dünn- bzw. Dickschicht ausgeführt. Die unterste Schicht 10 (Cu) und die erste mittlere Schicht 11 (Ni) sind vorzugsweise als Dickschichten ausgeführt. Die oberste Schicht 13 (Au) sowie die zweite mittlere Schicht 12 (Pd) sind vorzugsweise als Dünnschichten 12 ausgeführt. Die Schichtabfolge und -stärke ist dabei so gewählt, dass insbesondere ein zuverlässiger Löt- und Al Dickdrahtbondprozess ermöglicht wird.

Die Schichtdicken variieren dabei von ≤ 1 µm bis ≤ 20 µm, wobei die als Dickschicht ausgeführten Cu und Ni-Schichten 10, 11 jeweils bis zu 20 µm dick sein können. Die Pd- und Au-Schichten 12, 13 weisen jeweils eine Schichtstärke von ≤ 1 µm auf.

Die einzelnen Schichten 10, 11, 12, 13 der jeweiligen ersten Elektrode 4 sind durch einen kombinierten Prozess aus Sputern, CVD Prozess, PVD Prozess und/oder galvanischem Abscheiden auf die Oberseite 2a des Trägers 2 aufgebracht.

Die beiden ersten Elektroden 4 sind voneinander getrennt angeordnet. Die Elektroden 4 sind derart ausgestaltet, dass ein Freibereich an der Oberseite 2a ausgebildet ist, das heißt ein Bereich, welcher frei von Elektrodenmaterial ist. Insbesondere reichen die ersten Elektroden 4 nicht bis an den Rand der Oberseite 2a.

Die jeweilige erste Elektrode 4 weist einen ersten Bereich (Bondpad 4a) und einen zweiten Bereich (Lötpad 4b) auf. Der erste Bereich 4a ist größer ausgebildet als der zweite Bereich 4b. Der erste Bereich 4a weist eine Ausdehnung D1 parallel zu einer Längsachse L (siehe Figur 2) des Sensorelements 1 auf, wobei 0,2 mm ≤ D1 ≤ 1,5 mm. Vorzugsweise beträgt die Ausdehnung D1 = 0,9 mm. Der erste Bereich 4a weist eine Ausdehnung D2 senkrecht zur Längsachse L des Sensorelements 1 auf, wobei 0,2 mm ≤ D2 ≤ 2,0 mm. Vorzugsweise beträgt die Ausdehnung D2 = 1,1 mm.

Die beiden Bereiche 4a, 4b gehen ineinander über. Insbesondere sind die beiden Bereiche 4a, 4b durch einen stegförmigen Verbindungsbereich 4c miteinander verknüpft bzw. verbunden.

Die beiden ersten Elektroden 4 sind derart auf der Oberseite 2a orientiert, dass die beiden zweiten Bereiche / Lötpads 4b entlang einer Querachse Q des Trägers 2 gegenüberliegend angeordnet sind und dadurch das Auflöten eines NTC Thermistors 3 ermöglichen. Die Querachse Q verläuft dabei senkrecht zur Längsachse L (Figur 2). Insbesondere sind die zweiten Bereiche 4b in einem Mittelbereich der Oberseite 2a ausgebildet.

Optional kann auch ein Lötstopplack auf beiden Stegen der Elektrode auf der Oberseite 2a des Trägers 2 aufgebracht werden.

Das Sensorelement 1 weist den oben erwähnten NTC Thermistor 3 auf. The NTC Thermistor 3 ist in diesem Ausführungsbeispiel ein SMD NTC Thermistor. Der Einfachheit halber wird im Folgenden in Zusammenhang mit dem Ausführungsbeispiel gemäß der Figuren 1 bis 3 der Begriff "NTC Thermistor 3" statt "SMD NTC Thermistor 3" verwendet.

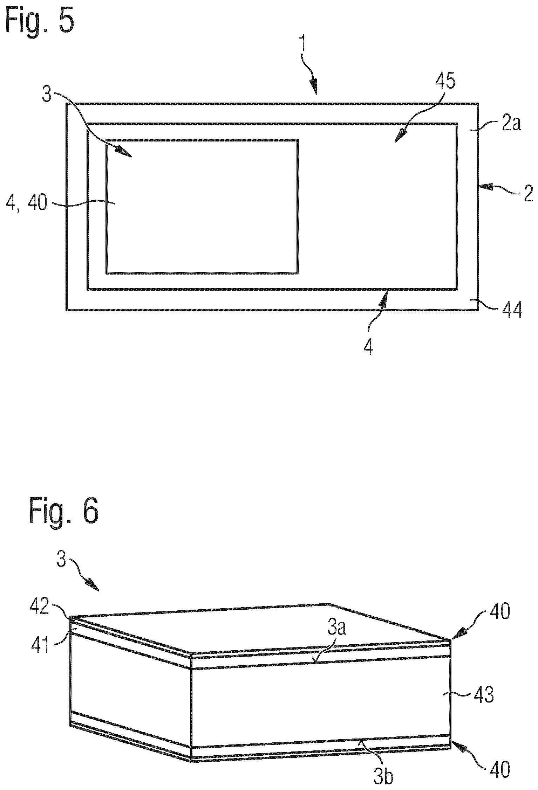

Alternativ dazu (siehe Ausführungsbeispiele gemäß der Figuren 5 und 6) kann der NTC Thermistor 3 auch ein Chip NTC Thermistor 3 sein. Der Einfachheit halber wird in Zusammenhang mit dem Ausführungsbeispiel gemäß der Figuren 5 und 6 der Begriff "NTC Thermistor 3" statt "Chip NTC Thermistor 3" verwendet.

Der NTC Thermistor 3 weist eine Oberseite 3a und eine Unterseite 3b auf (siehe hierzu Ausführungsbeispiel gemäß Figur 6). Der NTC Thermistor 3 weist eine Höhe h von 0,2 mm ≤ h ≤ 0,7 mm auf.

Der NTC Thermistor 3 ist an der Oberfläche des Sensorelements 1 angeordnet. Der NTC Thermistor 3 ist vorzugsweise ein EIA 0402 oder EIA 0201 SMD NTC. Alternativ kann der NTC Thermistor 3 auch ein EIA 01005 SMD NTC sein.

Vorzugsweise ist der NTC Thermistor 3 gemäß Figur 1 (SMD NTC Thermistor, Variante 1) auf die Oberseite 2a des Trägers 2 aufgelötet. Insbesondere ist der NTC Thermistor 3 auf die zweiten Bereiche 4b bzw. Lötpads 4b der ersten Elektroden 4 aufgelötet. Folglich ist der NTC Thermistor 3 im Mittelbereich der Oberseite 2a des Trägers 2 angeordnet.

Um Schädigungen der Verbindungsstellen zwischen NTC Thermistor 3 und Träger 2 durch zyklische Temperaturwechsel und dabei auftretende thermomechanische Spannungen zu vermeiden sind die Ausdehnungskoeffizienten von Trägermaterial und dem Keramikmaterial des NTC Thermistors 3 aufeinander abgestimmt.

In dem Ausführungsbeispiel gemäß der Figuren 1 bis 4 weist das Sensorelement 1 ferner eine Schutzschicht bzw. Schutzhülle 9 (Globtop) auf. Die Schutzhülle 9 umhüllt wenigstens den NTC Thermistor 3 vorzugsweise vollständig. Dadurch wird der NTC Thermistor 3 optimal gegen äußere Einflüsse geschützt.

Eine elektrische Kontaktierung des Sensorelements 1 wird durch Drahtbonden (vorzugsweise Al-Dickdrahtbonden) der ersten Elektroden 4, insbesondere der ersten Bereiche bzw. Bondpads 4a, erzielt. Beschädigungen der NTC Keramik können damit vermieden werden. Die Zuverlässigkeit des Sensorelements 1 im Gegensatz zu Stand der Technik NTC Thermistoren wird dadurch erhöht. Durch den stegförmigen Verbindungsbereich 4c zwischen dem ersten Bereich 4a und dem zweiten Bereich 4b wird durch das Drahtbonden ebenfalls der NTC Thermistor 3 kontaktiert.

Die zweite Elektrode 5 ist an der Unterseite 2b des Trägers 2 angeordnet. Die zweite Elektrode 5 ist dazu ausgebildet und angeordnet mit konventioneller AVT (vorzugsweise Löten oder Silbersintern) direkt auf die Leiterbahn eines Leistungsmoduls aufgebracht zu werden.

Die zweite Elektrode 5 kann mehrschichtig oder auch einschichtig ausgebildet sein. Beispielsweise kann die zweite Elektrode 5 lediglich eine oder mehrere Ag Schichten aufweisen (Dünnschichtelektrode). Alternativ dazu kann die zweite Elektrode 5 auch einen Schichtaufbau analog des Schichtaufbaus der jeweiligen ersten Elektrode 4 aufweisen (siehe auch Figur 4).

Bevorzugt ist die zweite Elektrode 5 vollflächig ausgebildet. Mit anderen Worten, die zweite Elektrode 5 erstreckt sich vollständig oder beinahe vollständig über die komplette Unterseite 2b des Trägers 2. An der Unterseite 2b kann aber auch ein Freirand 6 ausgebildet sein. In diesem Fall reicht die zweite Elektrode 5 nicht bis zu dem Rand der Unterseite 2b des Trägers 2.

An der Unterseite bzw. Außenseite der zweiten Elektrode 5 ist in diesem Ausführungsbeispiel eine Metallisierung 7, vorzugsweise eine Ag-Metallisierung, ausgebildet. Die Metallisierung 7 kann über einen CVD Prozess, einen PVD Prozess oder durch galvanische Abscheidung auf die zweite Elektrode 5 erzeugt werden. Durch die Metallisierung 7 wird die direkte Anbindung des Sensorelements 1 an die Leiterplatte durch Einsatz eines Silber-Sinterprozesses ermöglicht. Eine Metallisierung 7 wird insbesondere dann eingesetzt, wenn die zweite Elektrode 5 einen Schichtaufbau analog zu der jeweiligen ersten Elektrode 4 aufweist. Sofern die zweite Elektrode 5 als Ag-Dünnschichtelektrode ausgeführt ist, kann die Metallisierung 7 auch entfallen.

Zwischen der ersten Elektrode 4 und/oder der zweiten Elektrode 5 und dem Träger 2 kann ferner eine Haftvermittlungsschicht 8, beispielsweise eine Ti-Schicht, ausgebildet sein. In diesem Fall ist die Elektrode 4, 5 direkt auf der Haftvermittlungsschicht 8 ausgebildet. Dies ermöglicht eine besonders gute Anbindung der Elektroden 4, 5 an den Träger 2.

Gemäß einem weiteren Ausführungsbeispiel kann das Sensorelement 1 zur Vereinfachung des Aufbaus auch ohne eine zweite/untere Elektrode 5 ausgebildet sein.

Gemäß einem weiteren Ausführungsbeispiel kann das Sensorelement 1 auch für Dünndrahtbonden ausgelegt sein. In diesem Beispiel ist der NTC Thermistor 3 vorzugsweise ein SMD EIA 01005. Vorzugsweise weist der Träger 2 in diesem Ausführungsbeispiel folgende Abmessungen auf: 0,1 mm ≤ H ≤ 1 mm; 0,5 mm ≤ B ≤ 2,0 mm; 1,0 mm ≤ L ≤ 2,0 mm. Vorzugsweise weist der erste Bereich 4a der jeweiligen ersten Elektrode 4 die folgenden Abmessungen auf: 0,1 mm ≤ D1 ≤ 1,1 mm; 0,1 mm ≤ D2 ≤ 1,1 mm.

Gegenüber dem Stand der Technik ermöglicht das isolierende Sensorelement 1 eine Anwendung direkt auf der Leiterbahn eines Leistungsmoduls. Durch den speziellen Elektrodenaufbau ist eine Kontaktierung mit Al-Dickdraht ohne Beschädigung der NTC Keramik sowie mit gesteigerter Zuverlässigkeit im Gegensatz zu NTC Thermistoren gemäß dem Stand der Technik möglich. Zusätzlich wird die mechanische Stabilität des Sensorelementes 1 durch die Verwendung von keramischen Trägermaterialien auf Basis von z.B. AlN, Si₃N₄, Al₂0₃, LTCC bzw. ZTA Materialien erhöht.

Die Figuren 2 und 3 zeigen eine perspektivische Draufsicht (Figur 2) bzw. eine perspektivische Unteransicht (Figur 3) eines Sensorelements 1 gemäß einem weiteren Ausführungsbeispiel.

Im Gegensatz zu dem Sensorelement 1 gemäß Figur 1 weist das Sensorelement hierbei keine Schutzhülle 9 auf. Ferner ist das Sensorelement 1 ohne Metallisierung 7 und ohne Haftvermittlungsschicht 8 ausgebildet. Für alle weiteren Merkmale des Sensorelements 1 wird auf die Beschreibung im Zusammenhang mit der Figur 1 verwiesen.

Im Folgenden wird ein Verfahren zur Herstellung eines Sensorelements 1 beschrieben. Vorzugsweise wird durch das Verfahren das Sensorelement 1 gemäß einem der oben beschriebenen Ausführungsbeispiele (Figuren 1 bis 3) hergestellt. Alle Merkmale die in Zusammenhang mit dem Sensorelement 1 beschrieben wurden, finden daher auch für das Verfahren Anwendung und umgekehrt.

In einem ersten Schritt A) wird ein Trägermaterial zur Ausbildung des Trägers 2 bereitgestellt. Das Trägermaterial weist eine gute thermische Leitfähigkeit auf. Das Trägermaterial weist ein elektrisch isolierendes Material auf. Das Trägermaterial weist eine Keramik auf. Vorzugsweise weist das Trägermaterial eine Keramik auf Basis von Al₂O₃, LTCC oder ZTA Materialien auf. Alternativ kann das Trägermaterial auch AlN oder Si₃N₄ aufweisen.

In einem weiteren Schritt B) erfolgt das Aufbringen der wenigstens zwei ersten Elektroden 4 auf der Oberseite 2a des Trägermaterials. Dies geschieht durch einen kombinierten Prozess aus Sputtern, CVD Prozess, PVD Prozess und/oder galvanischem Abscheiden. Dabei werden mehrschichtige erste Elektroden 4 ausgebildet. Insbesondere weist die jeweilige erste Elektrode 4 einen Schichtaufbau aus einer untersten Schicht 10, zwei Mittelschichten 11, 12 und einer obersten Schicht 13 auf.

Zunächst wird die unterste Schicht 10 auf die Oberseite 2a des Trägermaterials abgeschieden, beispielsweise galvanisch. Die unterste Schicht 10 weist vorzugsweise Cu auf. Bevorzugt ist die unterste Schicht 10 eine Dickschicht. Vorzugsweise weist die unterste Schicht 10 eine Dicke zwischen 1 µm und 20 µm auf, besonders bevorzugt zwischen 3 µm und 15 µm.

Anschließend wird die erste mittlere Schicht 11 auf der untersten Schicht 10 ausgebildet, beispielsweise galvanisch. Die erste mittlere Schicht 11 weist Ni auf. Bevorzugt ist die erste mittlere Schicht 11 eine Dickschicht. Vorzugsweise weist die erste mittlere Schicht 11 eine Dicke zwischen 1 µm und 20 µm auf, besonders bevorzugt zwischen 3 µm und 7 µm.

Im Anschluss wird die zweite mittlere Schicht 12 auf der ersten mittleren Schicht 11 ausgebildet, beispielsweise mittels Sputtern. Die zweite mittlere Schicht 12 weist beispielsweise Pd auf. Bevorzugt ist die zweite mittlere Schicht 12 eine Dünnschicht. Vorzugsweise weist die zweite mittlere Schicht 12 eine Dicke von ≤ 1 µm auf.

Als letztes wird die oberste Schicht 13 auf der zweiten mittleren Schicht 12 ausgebildet, beispielsweise mittels Sputtern. Die oberste Schicht 13 weist Au auf. Die oberste Schicht 13 bildet die Oberseite bzw. Außenseite der jeweiligen ersten Elektrode 4. Bevorzugt ist die oberste Schicht 13 eine Dünnschicht. Vorzugsweise weist die oberste Schicht 13 eine Dicke von ≤ 1 µm auf.

In einem alternativen Ausführungsbeispiel erfolgt vor dem Schritt B) ein weiterer Schritt, in dem die Haftvermittlungsschicht 8 auf die Oberseite 2a des Trägermaterials aufgebracht wird. Anschließend werden in diesem Ausführungsbeispiel die ersten Elektroden 4 auf der Haftvermittlungsschicht 8 ausgebildet.

In einem weiteren Schritt C) erfolgt das Aufbringen der zweiten Elektrode 5 auf der Unterseite 2b des Trägermaterials. Dies kann ebenfalls durch einen kombinierten Prozess aus Sputtern, CVD Prozess, PVD Prozess und/oder galvanischem Abscheiden erfolgen. Die dabei entstehende zweite Elektrode 5 weist einen mehrschichtigen Aufbau auf, beispielsweise analog zu dem Aufbau der jeweiligen ersten Elektrode 4.

Alternativ dazu kann die zweite Elektrode 5 aber auch lediglich eine oder mehrere Schichten Ag aufweisen. In diesem Fall erfolgt das Aufbringen der zweiten Elektrode 5 auf die Unterseite 2a des Trägermaterials.

In einem alternativen Ausführungsbeispiel erfolgt vor dem Schritt C) ein weiterer Schritt, in dem die Haftvermittlungsschicht 8 auf die Unterseite 2b des Trägermaterials aufgebracht wird. Anschließend wird in diesem Ausführungsbeispiel die zweite Elektrode 5 auf der Haftvermittlungsschicht 8 ausgebildet.

In einem alternativen Ausführungsbeispiel kann Schritt C) weggelassen werden, so dass keine zweiten Elektrode 5 auf der Unterseite 2b des Trägermaterials aufgebracht wird.

In einem alternativen weiteren Schritt kann eine Metallisierung 7 auf der Unterseite bzw. Außenseite der zweiten Elektrode 5 ausgebildet werden. Die Metallisierung wird über einen CVD Prozess, einen PVD Prozess oder durch galvanische Abscheidung auf die zweite Elektrode 5 aufgebracht.

In einem nächsten Schritt D) erfolgt das Anordnen des NTC Thermistors 3 auf der Oberseite 2a des Trägermaterials. Insbesondere wird der NTC Thermistor 3 auf einen Teilbereich (zweiter Bereich 4b bzw. Lötpad 4b) der wenigstens zwei ersten Elektroden 4 aufgelötet.

In einem weiteren Schritt erfolgt das Aufbringen einer Schutzschicht bzw. Schutzhülle 9. Die Schutzhülle 9 weist vorzugsweise ein Polymer auf. Bevorzugt besteht die Schutzhülle 9 aus einem Polymer. Die Schutzhülle 9 umhüllt den NTC Thermistor 3 vorzugsweise vollständig.

Anschließend kann das direkte Anbinden des Sensorelements 1 auf eine Leiterbahn einer Leiterplatte erfolgen, insbesondere mittels einer konventionellen AVT, vorzugsweise durch Löten oder Ag-Sintern der zweiten Elektrode 5.

Ferner können nunmehr die ersten Elektroden 4 sowie der NTC Thermistor 3 kontaktiert werden. Dies erfolgt ebenfalls mittels einer konventionellen AVT, vorzugsweise mittels Drahtbonden (bevorzugt Al-Dickdrahtbonden) oder Löten.

Die Figur 5 zeigt ein Sensorelement 1 gemäß einem weiteren Ausführungsbeispiel. Im Gegensatz zu den in den Figuren 1 bis 3 gezeigten Ausführungsbeispielen ist der NTC Thermistor 3 hierbei ein Chip NTC Thermistor. Im Gegensatz zu den in den Figuren 1 bis 3 gezeigten Ausführungsbeispielen ist hierbei ferner lediglich eine Elektrode 4 unmittelbar auf der Oberseite 2a des Trägers 2 ausgebildet. Im Folgenden wird diese Elektrode als die erste obere Elektrode 4 bezeichnet. Die erste obere Elektrode 4 ist analog zu den oben beschriebenen ersten Elektroden 4 aufgebaut. Insbesondere ist die erste obere Elektrode mehrschichtig aufgebaut.

Die erste obere Elektrode 4 ist derart auf die Oberseite 2a des Trägers aufgebracht, dass ein Randbereich des Trägers 2 frei von der ersten oberen Elektrode 4 ist (Freirand 44). Der Freirand 44 weist eine Breite von 0,05 bis 0,25 mm auf.

Alternativ dazu und erfindungsgemäß bedeckt die erste obere Elektrode 4 die Oberseite 2a des Trägers 2 vollständig (nicht explizit dargestellt). Eine Fläche der ersten oberen Elektrode 4 beträgt in diesem Fall (1,25 ± 0,75) mm x (2,25 ± 1,25) mm auf.

Der NTC Thermistor 3 bedeckt die erste obere Elektrode 4 nicht vollständig. Wie aus Figur 5 ersichtlich ist, ist der NTC Thermistor 3 in einem Randbereich der ersten oberen Elektrode 4 angeordnet. Mit anderen Worten, ein Teilbereich 45 der ersten oberen Elektrode 4 ist frei vom NTC Thermistor 3. Dieser Teilbereich 45 dient als ein erstes Bondpad.

Der NTC Thermistor 3 weist eine Metallisierung 40 auf. Die Metallisierung 40 ist eine Dünnschichtmetallisierung. Die Metallisierung 40 ist an der Oberseite 3a des NTC Thermistors 3 ausgebildet, vorzugsweise aufgesputtert. Auf einer weiteren, gegenüberliegenden Seite des NTC Thermistors (Unterseite 3b) kann eine weitere Metallisierung 40 angeordnet sein (Figur 6).

Die Metallisierung 40 an der Oberseite 3a des NTC Thermistors 3 dient als weiteres Bondpad für eine Al-Dickdraht Kontaktierung des Sensorelements 1. Mit anderen Worten, die Metallisierung 40 des NTC Thermistors 3 fungiert als eine zweite obere Elektrode 4. Damit ist eine elektrische Kontaktierung des Sensorelements 1 auf einfache Weise gewährleistet.

Die Metallisierung 40 ist eine schichtförmige Elektrode mit mehreren Schichten 41, 42 (Figur 6). Die Schichten 41, 42 sind beispielsweise gesputtert. Die Metallisierung 40 weist eine Schicht 41 auf, welche direkt auf der Keramik des Grundkörpers 43 aufgebracht ist (Figur 6). Die Schicht 41 enthält Nickel, beispielsweise mit einem Anteil an Vanadium, oder besteht aus diesen Metallen.

Die Schicht 41 kann wiederum mehrschichtig ausgebildet sein (nicht explizit dargestellt). Eine untere Schicht der Schicht 41 ist beispielsweise in direktem Kontakt mit der Keramik. Die untere Schicht enthält beispielsweise Chrom oder besteht aus Chrom. Die Schicht 41 kann zudem eine obere Schicht aufweisen, die auf der unteren Schicht aufgebracht ist. Die obere Schicht enthält beispielsweise Nickel mit einem Anteil an Vanadium oder besteht aus diesen Metallen.

Die Schicht 41 weist beispielsweise eine Dicke im Bereich von 0,2 µm bis 10 µm auf. Vorzugsweise liegt die Dicke im Bereich von 0,3 µm bis 2 µm. Diese Dicke kann sowohl für eine einschichtige als auch eine mehrschichtige Schicht 41 gelten.

Auf der Schicht 41 ist eine weitere Schicht 42 (Deckschicht) aufgebracht. Beispielsweise dient die Deckschicht 42 als Korrosionsschutz für die Schicht 41, insbesondere zur Verhinderung einer Oxidation. Die Deckschicht enthält beispielsweise Silber, Gold, Kupfer oder Aluminium oder besteht aus einem dieser Materialien. Die Deckschicht weist beispielsweise eine Dicke im Bereich von 0,05 µm bis 20 µm auf.

Alle weiteren Merkmale des Sensorelements 1, insbesondere die zweite bzw. untere Elektrode 5, die Metallisierung 7 und die Haftvermittlungsschicht 8 sind analog zu den weiter oben beschriebenen Ausführungsbeispielen ausgeführt.

Im Folgenden wird ein Verfahren zur Herstellung eines Sensorelements 1 gemäß dem Ausführungsbeispiel der Figuren 5 und 6 beschrieben.

In einem ersten Schritt A) wird ein Trägermaterial zur Ausbildung des Trägers 2 bereitgestellt. Das Trägermaterial weist eine gute thermische Leitfähigkeit auf. Das Trägermaterial weist ein elektrisch isolierendes Material auf. Das Trägermaterial weist eine Keramik auf. Vorzugsweise weist das Trägermaterial eine Keramik auf Basis von AlN, Si₃N₄, Al₂O₃, LTCC oder ZTA Materialien auf.

In einem weiteren Schritt B) erfolgt das Aufbringen einer der beiden ersten Elektroden 4 (erste obere Elektrode 4) auf der Oberseite 2a des Trägermaterials. Dies geschieht durch einen kombinierten Prozess aus Sputtern, CVD Prozess, PVD Prozess und/oder galvanischem Abscheiden. Dabei wird eine mehrschichtige erste obere Elektrode 4 ausgebildet. Insbesondere weist die erste obere Elektrode 4 einen Schichtaufbau aus einer untersten Schicht 10, zwei Mittelschichten 11, 12 und einer obersten Schicht 13 auf (Figur 4). Der Schichtaufbau der ersten oberen Elektrode 4 erfolgt dabei analog zu dem Schichtaufbau der oben beschriebenen ersten Elektroden.

Die erste obere Elektrode 4 kann vollflächig auf der Oberseite 2a aufgebracht werden. Alternativ dazu wird die erste obere Elektrode 4 so aufgebracht, dass ein Randbereich des Trägers 2 frei bleibt (Freirand 44).

In einem alternativen Ausführungsbeispiel erfolgt vor dem Schritt B) ein weiterer Schritt, in dem die Haftvermittlungsschicht 8 auf die Oberseite 2a des Trägermaterials aufgebracht wird. Anschließend werden in diesem Ausführungsbeispiel die erste obere Elektrode 4 auf der Haftvermittlungsschicht 8 ausgebildet.

In einem weiteren Schritt C) erfolgt das Aufbringen der zweiten bzw. unteren Elektrode 5 auf der Unterseite 2b des Trägermaterials. Dies kann ebenfalls durch einen kombinierten Prozess aus Sputtern, CVD Prozess, PVD Prozess und/oder galvanischem Abscheiden erfolgen. Die dabei entstehende zweite Elektrode 5 weist einen mehrschichtigen Aufbau auf, beispielsweise analog zu dem Aufbau der jeweiligen ersten Elektrode 4. Alternativ dazu kann die zweite Elektrode 5 aber auch lediglich eine oder mehrere Schichten Ag aufweisen.

In einem alternativen Ausführungsbeispiel erfolgt vor dem Schritt C) ein weiterer Schritt, in dem die Haftvermittlungsschicht 8 auf die Unterseite 2b des Trägermaterials aufgebracht wird. Anschließend wird in diesem Ausführungsbeispiel die zweite Elektrode 5 auf der Haftvermittlungsschicht 8 ausgebildet.

In einem alternativen weiteren Schritt kann eine Metallisierung 7 auf der Unterseite bzw. Außenseite der zweiten Elektrode 5 ausgebildet werden. Die Metallisierung wird über einen CVD Prozess, einen PVD Prozess oder durch galvanische Abscheidung auf die zweite Elektrode 5 aufgebracht.

In einer alternativen Ausführungsform entfällt das Aufbringen der zweiten Elektrode 5 auf der Unterseite 2b des Trägermaterials. In diesem Fall erfolgt die Anbindung des Sensorelements 1 mittels Kleben.

In einem nächsten Schritt D) erfolgt das Anordnen des NTC Thermistors 3 auf einem Teilbereich der ersten oberen Elektrode 4. Insbesondere wird der NTC Thermistor 3 auf einen Randbereich der ersten oberen Elektrode 4 aufgelötet. Der NTC Thermistor 3 weist an der Oberseite 3a eine Metallisierung 40 auf, welche als zweite obere Elektrode 4 fungiert. Anschließend kann das direkte Anbinden des Sensorelements 1 auf eine Leiterbahn einer Leiterplatte erfolgen, insbesondere mittels einer konventionellen AVT, vorzugsweise durch Löten oder Ag-Sintern der zweiten Elektrode 5.

Ferner können nunmehr die ersten bzw. oberen Elektroden 4, 40 kontaktiert werden. Dies erfolgt ebenfalls mittels einer konventionellen AVT, vorzugsweise mittels Drahtbonden (bevorzugt Al-Dickdrahtbonden) oder Löten.

### Bezugszeichenliste

- 1: Sensorelement
- 2: Träger
- 2a: Oberseite
- 2b: Unterseite
- 3: NTC Thermistor
- 3a: Oberseite
- 3b: Unterseite
- 4: Erste/obere Elektrode
- 4a: Erster Bereich / Bondpad
- 4b: Zweiter Bereich / Lötpad
- 4c: Verbindungsbereich
- 5: Zweite/untere Elektrode
- 6: Freirand
- 7: Metallisierung
- 8: Haftvermittlungsschicht
- 9: Schutzschicht / Schutzhülle
- 10: Unterste Schicht
- 11: Mittlere Schicht
- 12: Mittlere Schicht
- 13: Oberste Schicht

- 40: Metallisierung
- 41: Schicht
- 42: Schicht / Deckschicht
- 43: Keramischer Grundkörper des NTC Thermistors
- 44: Freibereich
- 45: Teilbereich der ersten oberen Elektrode

- B: Breite des Sensorelements
- H: Höhe bzw. Dicke des Sensorelements
- L: Länge des Sensorelements
- h: Höhe des NTC Thermistors
- X: Längsachse
- Q: Querachse
- D1: Ausdehnung parallel zur Längsachse
- D2: Ausdehnung senkrecht zur Längsachse

## Patentansprüche

1. Sensorelement (1) zur Messung einer Temperatur aufweisend
- einen Träger (2), wobei der Träger (2) ein elektrisch isolierendes Material aufweist und wobei der Träger (2) eine Oberseite (2a) und eine Unterseite (2b) aufweist,
- einen NTC Thermistor (3), wobei der NTC Thermistor (3) an der Oberseite (2a) des Trägers (2) angeordnet ist,
- wenigstens zwei erste Elektroden (4, 40) zur elektrischen Kontaktierung des Sensorelements (1), wobei die ersten Elektroden (4, 40) an der Oberseite (2a) des Trägers (2) angeordnet sind, wobei eine erste Elektrode (4) der beiden ersten Elektroden (4, 40) unmittelbar auf der Oberseite (2a) des Trägers (2) ausgebildet ist, wobei der NTC Thermistor (3) direkt auf einen Teilbereich der ersten Elektrode (4) der beiden ersten Elektroden (13, 4) angeordnet ist, wobei der NTC Thermistor (3) eine Metallisierung (40) aufweist welche an einer Oberseite (3a) des NTC Thermistors (3) ausgebildet ist, und wobei die Metallisierung (40) eine zweite (40) der beiden ersten Elektroden (4, 40) bildet, wobei das Sensorelement (1) dazu ausgebildet ist elektrisch isolierend direkt integriert zu werden, **dadurch gekennzeichnet, dass** die erste Elektrode (4)der beiden ersten Elektroden (4, 40) die Oberseite (2a) des Trägers (2) vollflächig bedeckt.

2. Sensorelement (1) nach Anspruch 1,
wobei das Sensorelement (1) dazu ausgebildet ist elektrisch isolierend direkt auf eine Leiterbahn eines Leistungsmoduls integriert zu werden.

3. Sensorelement (1) nach Anspruch 1 oder 2,
wobei das elektrisch isolierende Material des Trägers (2) eine Keramik auf Basis von AlN, Si₃N₄, Al₂O₃, LTCC oder ZTA Materialien aufweist.

4. Sensorelement (1) nach einem der Ansprüche 1 bis 3,
wobei die Wärmeausdehnungskoeffizienten des Trägermaterials und eines Materials des NTC Thermistors (3) aufeinander abgestimmt sind.

5. Sensorelement (1) nach einem der vorangehenden Ansprüche, wobei wenigstens eine der ersten Elektroden (4) eine Mehrzahl von Schichten (10, 11, 12, 13) aufweist, und wobei die jeweilige erste Elektrode (4) Cu, Ni, Pd und/oder Au aufweist.

6. Sensorelement (1) nach Anspruch 5,
wobei wenigstens eine Schicht (10, 11) der ersten Elektrode (4) als Dickschicht ausgebildet ist und wobei wenigstens eine weitere Schicht (12,13) der ersten Elektrode (4) als Dünnschicht ausgebildet ist.

7. Sensorelement (1) nach einem der vorangehenden Ansprüche, wobei der NTC Thermistor (3) ein Chip NTC Thermistor ist.

8. Sensorelement (1) nach einem der vorangehenden Ansprüche, wobei die Metallisierung (40) zur elektrischen Kontaktierung des Sensorelements (1) mittels Drahtbonden ausgebildet ist.

9. Sensorelement (1) nach einem der vorangehenden Ansprüche, wobei die Metallisierung (40) wenigstens eine Schicht (41) enthaltend Nickel aufweist.

10. Sensorelement (1) gemäß Anspruch 9,
bei dem die Schicht (41) direkt auf einem keramischen Grundkörper (43) des NTC Thermistors (3) aufgebracht ist.

11. Sensorelement (1) nach einem der Ansprüche 9 oder 10, wobei die Schicht (41) zusätzlich einen Anteil an Vanadium enthält.

12. Sensorelement (1) nach einem der vorangehenden Ansprüche, wobei die Metallisierung (40) mehrere Schichten (41, 42) aufweist, die direkt übereinander angeordnet sind.

13. Sensorelement (1) nach einem der vorangehenden Ansprüche, ferner aufweisend wenigstens eine zweite Elektrode (5), wobei die zweite Elektrode (5) an der Unterseite (2b) des Trägers (2) angeordnet ist, wobei die zweite Elektrode (5) mehrschichtig ausgebildet ist und die Materialien Cu, Ni, Pd und/oder Au aufweist oder wobei die zweite Elektrode (5) wenigstens eine Schicht des Materials Ag aufweist.

14. Sensorelement (1) nach Anspruch 13,
wobei die zweite Elektrode (5) vollflächig auf der Unterseite (2b) des Trägers (2) ausgebildet ist.

15. Sensorelement (1) nach Anspruch 13 oder 14,
wobei die zweite Elektrode (5) derart angeordnet ist, dass an der Unterseite (2b) des Trägers (2) ein Freirand (6) ausgebildet ist.

16. Sensorelement (1) nach einem der Ansprüche 13 bis 15, wobei die zweite Elektrode (5) an der Oberseite eine Metallisierung (7) aufweist.

17. Sensorelement (1) nach einem der Ansprüche 1 und/oder 13, ferner aufweisend wenigstens eine Haftvermittlungsschicht (8), wobei die Haftvermittlungsschicht (8) zwischen wenigstens einer der ersten Elektroden (4) und dem Träger (2) und/oder zwischen der zweiten Elektrode (5) und dem Träger (2) ausgebildet ist.

18. Verfahren zur Herstellung eines Sensorelements (1) nach einem der vorangehenden Ansprüche aufweisend die folgenden Schritte:
A) Bereitstellen eines Trägermaterials zur Ausbildung des Trägers (2);
B) Aufbringen von wenigstens einer ersten Elektrode (4) auf einer Oberseite (2a) des Trägermaterials;
C) Aufbringen von wenigstens einer zweiten Elektrode (5) an einer Unterseite (2b) des Trägermaterials;
D) Anordnen eines NTC Thermistors (3) auf der ersten Elektrode (4), wobei der NTC Thermistor (3) auf einen Teilbereich der ersten Elektrode (4) aufgebracht wird und wobei der NTC Thermistor (3) eine Metallisierung (40) aufweist, die als eine weitere erste Elektrode (4) fungiert.

19. Verfahren nach Anspruch 18,
wobei der NTC Thermistor (3) ein Chip NTC Thermistor ist.

## Claims

1. Sensor element (1) for measuring a temperature, comprising:
- a carrier (2), wherein the carrier (2) comprises an electrically insulating material and wherein the carrier (2) comprises a top side (2a) and an underside (2b),
- an NTC thermistor (3), wherein the NTC thermistor (3) is arranged on the top side (2a) of the carrier (2),
- at least two first electrodes (4, 40) for electrically contacting the sensor element (1), wherein the first electrodes (4, 40) are arranged on the top side (2a) of the carrier (2), wherein a first electrode (4) of the two first electrodes (4, 40) is formed directly on the top side (2a) of the carrier (2), wherein the NTC thermistor (3) is arranged directly on a portion of the first electrode (4) of the two first electrodes (13, 4), wherein the NTC thermistor (3) comprises a metallization (40) formed on a top side (3a) of the NTC thermistor (3), and wherein the metallization (40) forms a second (40) of the two first electrodes (4, 40),
wherein the sensor element (1) is configured to be integrated directly in an electrically insulating manner, **characterized in that** the first electrode (4) of the two first electrodes (4, 40) covers the whole area of the top side (2a) of the carrier (2).

2. Sensor element (1) according to claim 1,
wherein the sensor element (1) is configured to be integrated directly onto a conductor track of a power module in an electrically insulating manner.

3. Sensor element (1) according to claim 1 or 2, wherein the electrically insulating material of the carrier (2) comprises a ceramic based on AlN, Si₃N₄, Al₂O₃, LTCC or ZTA materials.

4. Sensor element (1) according to any one of claims 1 to 3, wherein the coefficients of thermal expansion of the carrier material and of a material of the NTC thermistor (3) are matched to one other.

5. Sensor element (1) according to any one of the preceding claims,
wherein at least one of the first electrodes (4) comprises a plurality of layers (10, 11, 12, 13), and wherein the respective first electrode (4) comprises Cu, Ni, Pd and/or Au.

6. Sensor element (1) according to claim 5,
wherein at least one layer (10, 11) of the first electrode (4) is configured as a thick-film layer and wherein at least one further layer (12, 13) of the first electrode (4) is configured as a thin-film layer.

7. Sensor element (1) according to any one of the preceding claims, wherein the NTC thermistor (3) is a chip NTC thermistor.

8. Sensor element (1) according to any one of the preceding claims, wherein the metallization (40) is configured for electrically contacting the sensor element (1) by means of wire bonding.

9. Sensor element (1) according to any one of the preceding claims, wherein the metallization (40) comprises at least one layer (41) containing nickel.

10. Sensor element (1) according to claim 9,
wherein the layer (41) is applied directly on a ceramic main body (43) of the NTC thermistor (3).

11. Sensor element (1) according to either of claims 9 and 10,
wherein the layer (41) additionally contains a proportion of vanadium.

12. Sensor element (1) according to any one of the preceding claims, wherein the metallization (40) comprises a plurality of layers (41, 42) arranged one directly above another.

13. Sensor element (1) according to any one of the preceding claims, furthermore comprising at least one second electrode (5), wherein the second electrode (5) is arranged on the underside (2b) of the carrier (2), wherein the second electrode (5) is formed in multilayered fashion and comprises the materials Cu, Ni, Pd and/or Au or wherein the second electrode (5) comprises at least one layer of the material Ag.

14. Sensor element (1) according to claim 13,
wherein the second electrode (5) is formed over the whole area on the underside (2b) of the carrier (2).

15. Sensor element (1) according to claim 13 or 14, wherein the second electrode (5) is arranged in such a way that a free edge (6) is formed on the underside (2b) of the carrier (2).

16. Sensor element (1) according to any one of claims 13 to 15,
wherein the second electrode (5) comprises a metallization (7) on the top side.

17. Sensor element (1) according to any one of claims 1 and/or 13, furthermore comprising at least one adhesion promoting layer (8), wherein the adhesion promoting layer (8) is formed between at least one of the first electrodes (4) and the carrier (2) and/or between the second electrode (5) and the carrier (2).

18. Method for producing a sensor element (1) according to any one of the preceding claims, comprising the following steps:
(A) providing a carrier material for forming the carrier (2);
(B) applying at least one first electrode (4) on a top side (2a) of the carrier material;
(C) applying at least one second electrode (5) to an underside (2b) of the carrier material;
D) arranging an NTC thermistor (3) on the first electrode (4), wherein the NTC thermistor (3) is applied to a portion of the first electrode (4), and wherein the NTC thermistor (3) comprises a metallization (40) functioning as a further first electrode (4).

19. Method according to claim 18,
wherein the NTC thermistor (3) is a chip NTC thermistor.

## Revendications

1. Élément capteur (1) pour la mesure d'une température, comprenant
- un élément porteur (2), l'élément porteur (2) possédant un matériau électriquement isolant et l'élément porteur (2) possédant un côté supérieur (2a) et un côté inférieur (2b),
- une thermistance CTN (3), la thermistance CTN (3) étant disposée sur le côté supérieur (2a) de l'élément porteur (2),
- au moins deux premières électrodes (4, 40) destinées à la mise en contact électrique de l'élément capteur (1), les premières électrodes (4, 40) étant disposées sur le côté supérieur (2a) de l'élément porteur (2), une première électrode (4) des deux premières électrodes (4, 40) étant formée directement sur le côté supérieur (2a) de l'élément porteur (2), la thermistance CTN (3) étant disposée directement sur une zone partielle de la première électrode (4) des deux premières électrodes (13, 4), la thermistance CTN (3) possédant une métallisation (40) qui est formée sur un côté supérieur (3a) de la thermistance CTN (3), et la métallisation (40) formant une deuxième (40) des deux premières électrodes (4, 40), l'élément capteur (1) étant configuré pour être intégré directement de manière électriquement isolante, **caractérisé en ce que** la première électrode (4) des deux premières électrodes (4, 40) recouvre le côté supérieur (2a) de l'élément porteur (2) sur toute la surface.

2. Élément capteur (1) selon la revendication 1, l'élément capteur (1) étant configuré pour être intégré directement de manière électriquement isolante sur une piste conductrice d'un module de puissance.

3. Élément capteur (1) selon la revendication 1 ou 2, le matériau électriquement isolant de l'élément porteur (2) possédant une céramique à base de matériaux AlN, Si₃N₄, Al₂O₃, LTCC ou ZTA.

4. Élément capteur (1) selon l'une des revendications 1 à 3, les coefficients de dilatation thermique du matériau d'élément porteur et d'un matériau de la thermistance CTN (3) étant accordés l'un à l'autre.

5. Élément capteur (1) selon l'une des revendications précédentes,
au moins l'une des premières électrodes (4) possédant une pluralité de couches (10, 11, 12, 13), et la première électrode (4) respective présentant du Cu, du Ni, du Pd et/ou de l'Au.

6. Élément capteur (1) selon la revendication 5,
au moins une couche (10, 11) de la première électrode (4) étant réalisée sous forme de couche épaisse et au moins une couche supplémentaire (12, 13) de la première électrode (4) étant réalisée sous forme de couche mince.

7. Élément capteur (1) selon l'une des revendications précédentes, la thermistance CTN (3) étant une puce de thermistance CTN.

8. Élément capteur (1) selon l'une des revendications précédentes, la métallisation (40) étant configurée pour établir un contact électrique avec l'élément capteur (1) au moyen d'une connexion par fil.

9. Élément capteur (1) selon l'une des revendications précédentes, la métallisation (40) possédant au moins une couche (41) contenant du nickel.

10. Élément capteur (1) selon la revendication 9,
avec lequel la couche (41) est appliquée directement sur un corps de base en céramique (43) de la thermistance CTN (3).

11. Élément capteur (1) selon l'une des revendications 9 ou 10,
la couche (41) contenant en plus une proportion de vanadium.

12. Élément capteur (1) selon l'une des revendications précédentes, la métallisation (40) possédant plusieurs couches (41, 42) qui sont disposées directement les unes au-dessus des autres.

13. Élément capteur (1) selon l'une des revendications précédentes, possédant en outre au moins une deuxième électrode (5), la deuxième électrode (5) étant disposée au niveau du côté inférieur (2b) de l'élément porteur (2), la deuxième électrode (5) étant de configuration multicouche et présentant les matériaux Cu, Ni, Pd et/ou Au ou la deuxième électrode (5) présentant au moins une couche du matériau Ag.

14. Élément capteur (1) selon la revendication 13,
la deuxième électrode (5) étant formée sur toute la surface du côté inférieur (2b) de l'élément porteur (2).

15. Élément capteur (1) selon la revendication 13 ou 14, la deuxième électrode (5) étant disposée de telle sorte qu'un bord libre (6) est formé sur le côté inférieur (2b) de l'élément porteur (2).

16. Élément capteur (1) selon l'une des revendications 13 à 15,
la deuxième électrode (5) présentant une métallisation (7) sur le côté supérieur.

17. Élément capteur (1) selon l'une des revendications 1 et/ou 13, possédant en outre au moins une couche d'adhérence (8), la couche d'adhérence (8) étant formée entre au moins l'une des premières électrodes (4) et l'élément porteur (2) et/ou entre la deuxième électrode (5) et l'élément porteur (2).

18. Procédé de fabrication d'un élément de capteur (1) selon l'une des revendications précédentes, comprenant les étapes suivantes :
A) fourniture d'un matériau porteur pour former l'élément porteur (2) ;
B) application d'au moins une première électrode (4) sur un côté supérieur (2a) du matériau porteur ;
C) application d'au moins une deuxième électrode (5) sur un côté inférieur (2b) du matériau porteur ;
D) disposition d'une thermistance CTN (3) sur la première électrode (4), la thermistance CTN (3) étant appliquée sur une zone partielle de la première électrode (4) et la thermistance CTN (3) possédant une métallisation (40) qui fait office d'une première électrode supplémentaire (4).

19. Procédé selon la revendication 18,
la thermistance CTN (3) étant une puce de thermistance CTN.
